(19) Europäisches Patentamt

European Patent Office

Office européen des brevets

(11) **EP 1 515 235 A1**

(12) **EUROPEAN PATENT APPLICATION**

(43) Date of publication:
**16.03.2005 Bulletin 2005/11**

(51) Int Cl.⁷: **G06F 11/10**, H04L 1/00,
G06F 11/07

(21) Application number: **04255401.4**

(22) Date of filing: **07.09.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **10.09.2003 JP 2003318705**

(71) Applicant: **FANUC LTD
Minamitsuru-gun, Yamanashi 401-0597 (JP)**

(72) Inventors:
• **Aoyama, Kazunari, Room 11-301
Minamitsuru-gun Yamanashi 401-0511 (JP)**

• **Aizawa, Yasuharu
Minamitsuru-gun Yamanashi 401-0302 (JP)**
• **Komaki, Kunitaka, Room 7-309
Minamitsuru-gun Yamanashi 401-0511 (JP)**

(74) Representative: **Billington, Lawrence Emlyn
Haseltine Lake,
Imperial House,
15-19 Kingsway
London WC2B 6UD (GB)**

(54) **Error decoding circuit, data bus control method and data bus system**

(57) An error decoding circuit comprises a syndrome computing circuit (1a) for computing a syndrome on a receive data, an error detecting circuit (1b) for detecting an error based on the syndrome, an error pattern computing circuit (1c) for computing an error pattern based on the syndrome, and an inverting circuit (1d) for performing an error correction of a receive data based on the computed error pattern. Only when there is an error in the receive data, based on the detection result of the error detecting circuit (1b), a request signal for extension of a bus cycle is outputted to a bus master (2). On the other hand, if there is no error in the receive data, an inputted data is outputted to a data bus without correction. By so doing, the high speed operation of the data bus is executed.

FIG.1

**Description**

BACKGROUND OF THE INVENTION

1. Field of the Invention

The present invention relates to a data processing for performing a correction processing of a receive data and obtaining a corrected data, and particularly, it relates to an error decoding circuit for decoding the receive data, a control method for connecting a data bus to which the error decoding circuit is connected, and a system including the data bus.

2. Description of the Related Art

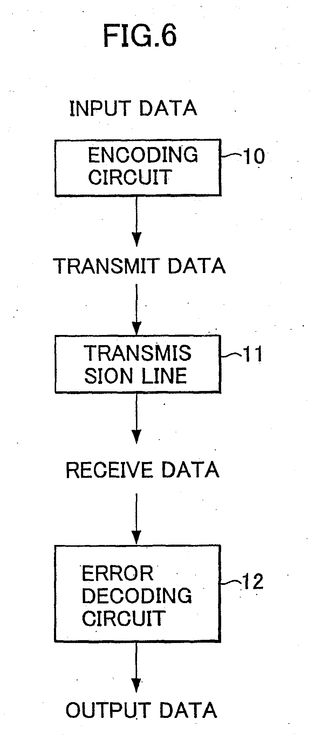

There is known, in general, a method for using an error correction code to correct an error in a data. Here, an outline of the error correction using the error correction code will be described with reference to FIG. 6.

In FIG. 6, an input data is encoded by an encoding circuit 10. The encoding circuit 10 forms, for example, a check bit based on a parity check matrix to be described later, and prepares a transmit data by attaching this check bit to the input data.

The transmit data is transmitted to a transmission line 11, and the transmission line 11 transmits the receive data to a communication destination. The communication destination decodes the receive data received by an error decoding circuit 12 and generates an output data.

In general, the transmission line 11 has disturbance factors to cause malfunctions, external noises and the like, and the receive data has a possibility of including an error. The error decoding circuit 12 comprises a function to correct this error. The transmission line is not limited to the usual communication channel, but can be adapted to a memory device in a memory system, and the transmit data is adapted to write information to the memory device, and the receive data can be also adapted to read information from the memory device.

The transmit data added with the check bit and encoded can be generally expressed by the binary number of n bits, and this transmit data can be expressed by $D = (d_0, d_1, ... d_{n-1})$ which includes the check bit of r bits. An encoding can be expressed by the parity check matrix (hereinafter, referred to as H matrix) of an r row and n column which are constituents of the binary number of 0 and 1, and the following relationship is established between the transmit data D including no error and the H matrix. That is, the check bit of the transmit data D is set down so that the following relationship is established.

$$D \cdot H^T = 0 \qquad (1)$$

where $H^T$ is an inverse matrix, which replaces the column with the row of H.

The computing result of the equation (1) is referred to as a syndrome S, and is expressed by a vector comprising r bits. If this syndrome S stands for S = 0, it is determined that there is no error, and if S ≠ 0, it is determined that there is an error. Further, by analyzing the pattern of this syndrome S based on the H matrix, it is possible to find the position and the size of the error so that the data including the error can be corrected.

If no error develops during the transmission, the receive data becomes identical with the transmit data. Consequently, since the transmit data D is formed in such a manner as to satisfy the above described equation (1), if there is no error in the receive data, a computing result obtained by taking D in the left side of the above described equation (1) as the receive data becomes 0 (zero vector of r bits). On the other hand, if there develops an error, the computing result obtained by taking D in the left side of the above described equation (1) as the receive data does not become 0. By analyzing the vector of r bits of this computing result based on the H matrix, it is possible to find the position and the size of the error of the receive data so that the receive data can be corrected.

In general, when the accuracy of the error detection and the error correction of the error decoding circuit is enhanced, the scale of the circuit also becomes large. In case of using the above-described error decoding circuit, regardless of the presence or absence of the error in the receive data, all the receive data are passed through the error decoding circuit. Therefore, when a highly accurate error detection and an error correction are required, even those receive data which are not required to be subjected to the error correction, have to pass through a circuit of large scale, and this creates a problem of a high speed operation becoming difficult.

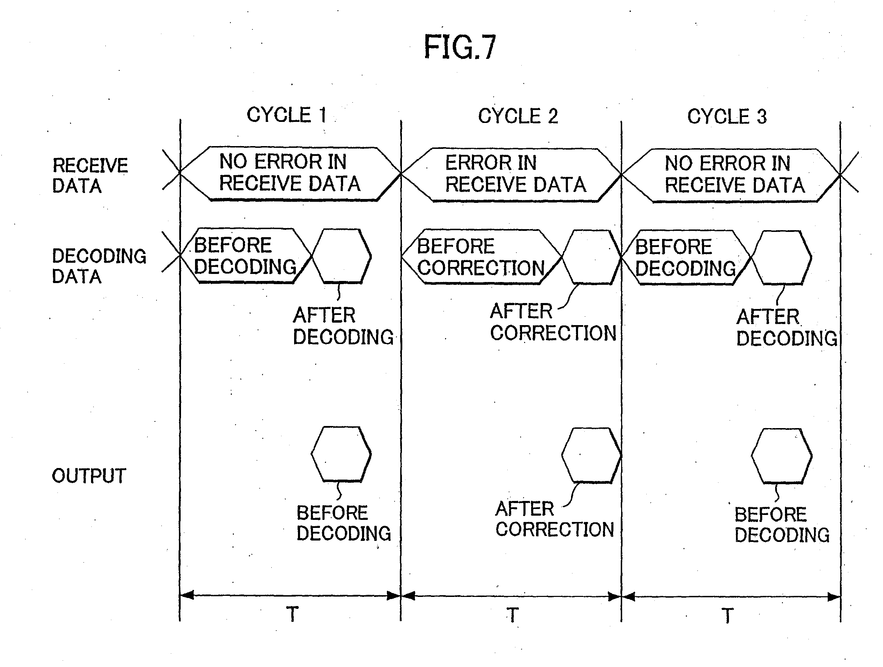

FIG. 7 is a view to explain about a data processing cycle of the conventional error decoding circuit. As shown in FIG. 7, the conventional error decoding circuit, regardless of whether or not there is an error included in the receive data, is set in such a manner that the processing of each error decoding is performed with the same cycle T as an unit. In a cycle 1 to a cycle 3 shown in FIG. 7, the receive data processed at the cycles 1 and 3 are regarded as not including an error, while the receive data processed at the cycle 2 is regarded as including the error.

Since a cycle time is set in conformity to the error correction processing which requires a long period of processing time, the processing which does not perform an correction error, but simply performs the decoding alone ends up completing the processing at an earlier period of time within the set cycle time. Consequently, the processing speed of this error decoding circuit is decided by the cycle time in which the error correction is executed.

As a technology which solves such a problem as carried by the error decoding circuit and executes a high speed operation, there has been proposed a method using a CRC code in Japanese Patent Application Laid-Open No. 5-218883.

This method is a method which adds the CRC code to a data portion, and provides an error code (ECC) for the data portion including the CRC code, wherein the CRC check is performed at the data portion excluding the error code, and when there is an error in the data, the corrected data in which the error is corrected in the error correction circuit is used, and when there is no error in the data, the receive data which is not allowed to pass through the correction circuit is used, thereby making an attempt to speed up.

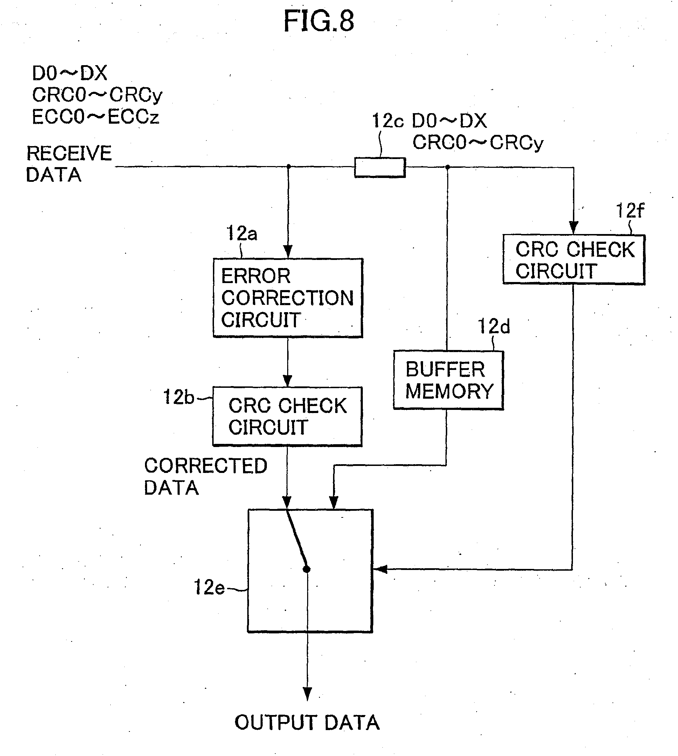

FIG. 8 is a block diagram to explain about one configuration example for this conventional high speed operation. In FIG. 8, the receive data includes data D0 to Dx, CRC codes CRC0 to CRCy, and error codes ECC0 to ECCZ. The receive data is processed by two systems. One data is error-corrected in an error correction circuit 12a, and after that, it is error-detected in a CRC check circuit 12b, and is outputted as a corrected data. The other data is temporarily stored in a buffer memory 12d with the data D0 to Dx and CRC codes CRC0 to CRCy obtained through a switch 12c not subjected to the correction processing.

The corrected data obtained and a non-corrected data by the above described two systems are selected by a selection circuit 12e, and are outputted as an output data. The selection by this selection circuit 12e is performed by a selection signal obtained by a CRC check circuit 12f which is additionally prepared, and when there is an error, the corrected data in which the error is corrected in the error correction circuit 12a is selected, and where there is no error, the non-corrected data stored in a buffer 12d is selected.

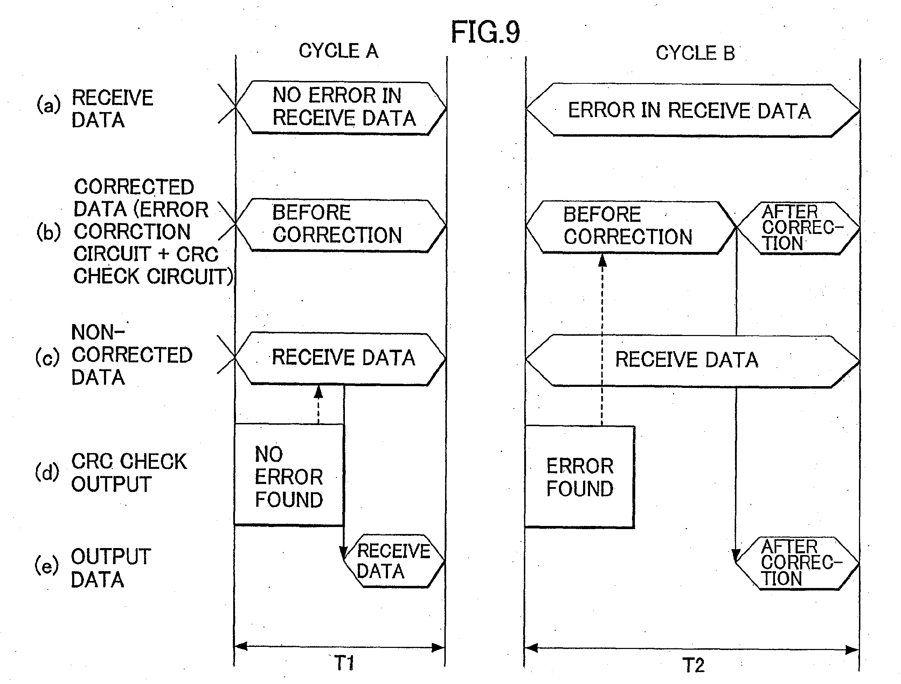

FIG. 9 is a view to show a cycle example in the case where there is no error in the receive data and the case where there is an error in the configuration example of the high speed operation.

When there is an error in the receive data (cycle B), the receive data ((a) in FIG. 9) selects ((e)) a corrected data ((c)) obtained in the correction processing by the error correction circuit based on the result of the CRC check ((d)), and therefore, the cycle time becomes "T2".

On the other hand, when there is no error in the receive data (cycle A) , the receive data ((a) in FIG. 9) either does not perform the correction processing by the error correction circuit ((b)) based on the result of the CRC check ( (d) ) nor selects the corrected data obtained in the error correction circuit, but selects ((e)) the non-corrected data ((c)), and therefore, the cycle time becomes "T1", which is shorter than T2 by the time when the receive data is corrected.

The configuration using the above described CRC check circuit is effective to shorten the cycle time in each error decoding circuit, but is unable to speed up the bus cycle of the data bus system to which the device including these error decoding circuits is connected. This is because the data bus system controls andmanages apluralityof bus slaves connected to a commonbus by a bus master. The bus master performs control and management according to the bus cycle set by the data bus system.

This bus cycle is required to be aligned with the longest cycle within the bus cycle of the bus slaves, even if the cycle of the error decoding circuit provided for each bus slave is switched according to the error situation of the data, and since the bus master operates based on the bus cycle set for the whole data bus system, there is a problem in that such a change in cycle would not lead to a high speed operation of the data bus system.

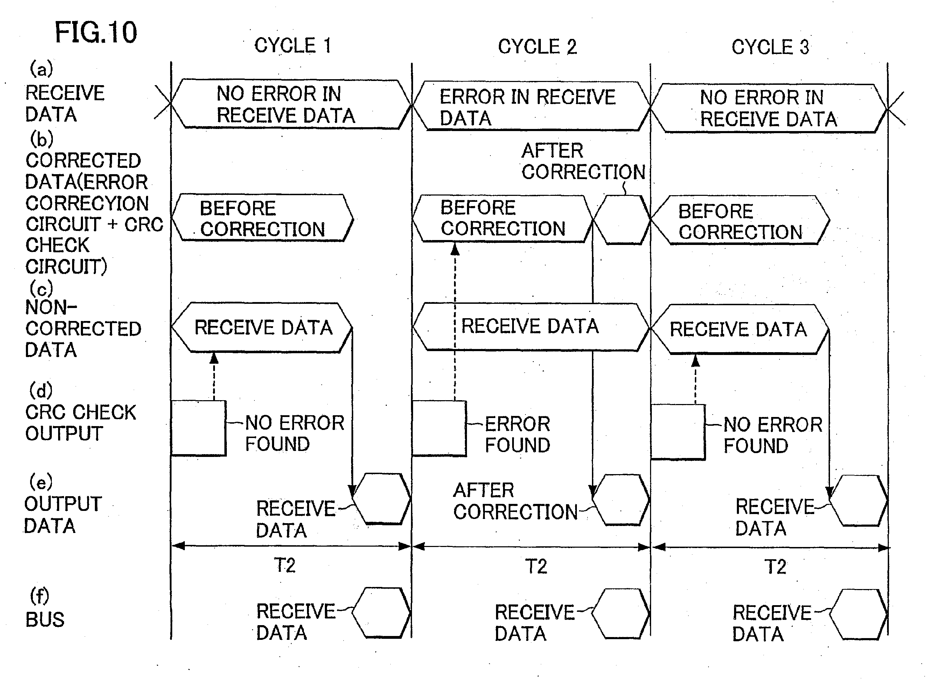

FIG. 10 is a view to explain about the bus cycle in case of adapting the configuration, which uses the conventional CRC check circuit, to the data bus system. When there is no error in the receive data, as shown in FIG. 9, the cycle time becomes T1 which can be made shorter, but when there is en error in the receive data, as shown in FIG. 9, the cycle time becomes T2 and becomes longer, and therefore, it is necessary for the data bus system to use the longer cycle time T2 if the receive data is processed in the same cycle time.

Further, in case of the configuration using the conventional CRC check circuit, since CRC code is used, the CRC check for the data after the error is corrected has to be separately performed, and therefore, along with the CRC check circuit (CRC check circuit 12f in FIG. 8), a CRC check circuit (CRC check circuit 12b in FIG. 8) for use of the data after correction is additionally required, and this creates a problem of the CRC check circuit being doubly required.

Further, an error correction code is required even for the CRC code, and therefore, in addition to the problem of the scale of the error correction circuit becoming larger, there is also a problem of the processing time becoming longer.

SUMMARY OF THE INVENTION

In the present invention, if there is no error in a receive data, the inputted data is outputted to the data bus without correction, while if there is an error in the receive data, the error is corrected in the error decoding circuit so as to extend a bus cycle, thereby attempting to speed up the operation of the data bus.

The present invention includes the error decoding circuit, the control method of the data bus and each mode of this data bus system.

The error decoding circuit according to the present invention performs a processing including the error correction of a receive data, and comprises a syndrome computing circuit for computing an syndrome on the receive data, an error detecting circuit for detecting an error based on the computed syndrome, an error pattern computing circuit for computing an error pattern based on the syndrome, and an inverting circuit for performing an error correction of a receive data based on the computed error pattern. Based on the detection result of the error detecting circuit, a request for the extension of the bus cycle is outputted to a bus master, if there is an error in the receive data.

By outputting a request signal for the extension of the bus cycle to the bus master when there is an error in the receive data, the bus master usually performs the processing by the bus cycle which is usually short, and the bus cycle is extended based on the request signal for the extension only when the error correction is made by the error decoding circuit. In general, the frequency of the error being developed in the data is low, and the majority of the data is not corrected in the cycle. Therefore, according to the present invention, the bus cycle which is not corrected and short in the cycle is set up as an ordinary bus cycle, and the bus cycle is extended only when the error correction is performed, so that the processing by the short cycle is performed for most of the cases. By so doing, the speeding up of the data bus cycle is realized.

The error decoding circuit drives the error pattern computing circuit and outputs an request signal for extension of a bus cycle, when there is an error in the receive data. The error decoding circuit, on the other hand, outputs the receive data inputted to the inverting circuit as it is, when there is no error in the receive data. This error detecting circuit detects an error based on the syndrome, and therefore, the addition of the CRC circuit as practiced conventionally is made redundant.

In the error decoding circuit, the inverting circuit inverts and corrects the receive data based on the error pattern. When no error correction is performed, the inverting circuit allows the inputted data topass through as it is, and therefore, the inverting circuit can perform the processing for the case where the error correction is executed only by the inverting circuit and for the case where no error correction is executed.

The control method of the data bus according to the present invention is a method for controlling the data bus, composed by connecting the bus master and at least one bus slave through a bus, according to the bus cycle, and this bus cycle is changed based on the detection result of the detection of the error of the receive data in the bus slave.

The bus slave performs the detection of the error of the receive data, and outputs the request signal for extension of the bus cycle based on the detection result of the detection of this error, while, on the other hand, the bus master extends the bus cycle based on the request signal for extension, and performs a control of the data in the interior of the bus according to an extended cycle time.

Further, the bus slave outputs the request signal for extension every time an error is detected in the receive data, and the bus master extends only one bus cycle for every output of the request signal for extension. The bus master performs the extension of only one bus cycle for one request signal for extension, and after the extension of the one bus cycle is completed, the processing is performed by the original bus cycle.

The data bus system according to the present invention is a data bus system composed by connecting the bus master and at least one bus slave through the bus, and the bus slave outputs a request signal for extension of the bus cycle at the time of detecting the error of the receive data.

The bus slave comprises error detection means for detecting the error of the receive data and outputting the request signal for extending the cycle time of the bus cycle based on the detection result. The bus master comprises control means for extending the bus cycle based on the request signal for extension and controlling the data in the interior the bus by the extended cycle time.

In a data bus system composed by connecting the bus master and at least one bus slave though the bus, the bus slave comprises an error decoding circuit comprising: a syndrome computing circuit for computing a syndrome on the receive data; error detection means for detection an error based on the computed syndrome; a pattern computing circuit for computing an error pattern based on the syndrome; and an error decoding circuit comprising an inverting circuit for correcting the error of the receive data based on the computed error pattern; wherein the error decoding circuit outputs a request signal for extension of the bus cycle for the bus master when there is an error in the receive data based on the detection result of the error detecting circuit.

The error decoding circuit, the control method of the data bus and the data bus system of the present invention are such that, when there is no error in the receive data, the inputted data is outputted to the data bus without correction, and when there is an error, the bus cycle is extended only when the correction is performed in the error decoding circuit, so that the data bus can be operated at high speed.

According to the present invention, the data bus can be operated at high speed.

According to the error decoding circuit of the present invention, the error correction is performed only when there is an error in the data, and at the same time, the request for extension of the cycle is outputted to the bus master, so that the processing of the error decoding circuit can be performed at high speed and the speeding up of the data bus cycle can be executed. Further, the configuration of the error decoding circuit for speeding up the data bus cycle can be simplified.

According to the data bus control method and the data bus system of the present invention, by switching the data bus cycle based on the request for extension of the cycle from the bus slave, the bus master can speed up the data bus cycle.

BRIEF DESCRIPTION OF THE DRAWINGS

The forgoing and other objects and feature of the invention will be apparent from the following description of preferred embodiments of the invention with reference to the accompanying drawings, in which:

FIG. 1 is a view to explain about the outline of an error decoding circuit of the present invention;
FIG. 2 is a flowchart to explain about a procedure of the processing of the error decoding circuit of the present invention;
FIG. 3 is a view to explain about an extension processing of the cycle time of a data bus cycle according to the present invention;
FIG. 4 is a block diagram to explain about the configuration of a data bus system;
FIG. 5 is a flowchart to explain about the procedure of the processing of a bus master side of the present invention;
FIG. 6 is a view to explain about the outline of en error correction using an error correction code;
FIG. 7 is a view to explain about a data processing cycle of the conventional error decoding circuit;
FIG. 8 is a block diagram to explain about one configuration example for the conventional high speed operation;
FIG. 9 is a view to show a cycle example in the case where there is an error in the receive data and the case where there is no error in a receive data in the configuration example of the conventional high speed operation; and
FIG. 10 is a view to show a bus cycle where the configuration using the conventional CRC check circuit is adapted to the data bus system.

DESCRIPTION OF THE EMBODIMENTS

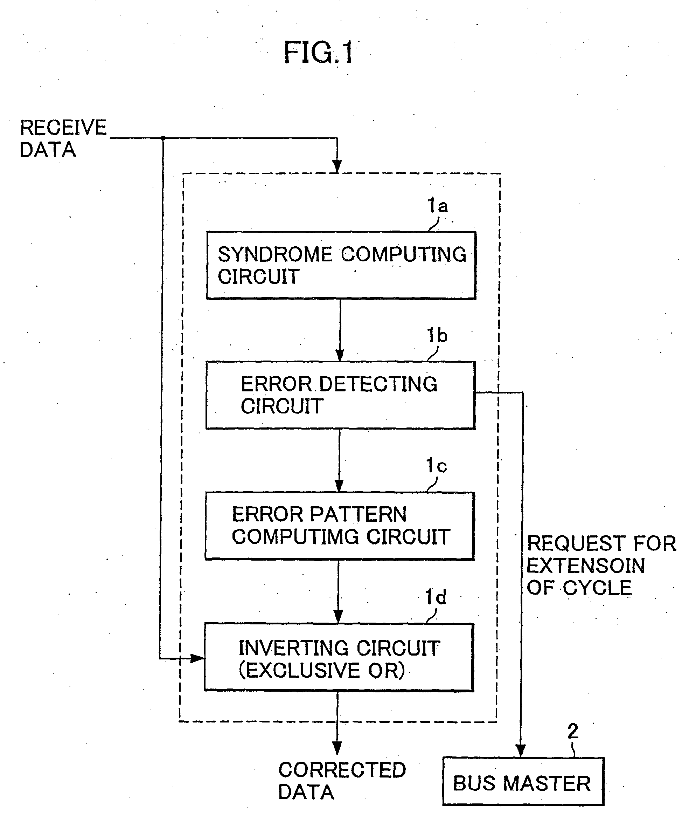

FIG. 1 is a view to explain about the outline of an error decoding circuit of the present invention. An error decoding circuit 1 shown in FIG. 1 comprises a syndrome computing circuit 1a for inputting a receive data and computing its syndrome, an error detecting circuit 1b for detecting an error based on the computed syndrome, en error pattern computing circuit 1c for computing an error pattern based on the syndrome when the error is detected, and an inverting circuit 1d for correcting the error of the receive data based on the error pattern computed.

The error detecting circuit 1b outputs a request signal for extension of a bus cycle to a bus master 2 when, based on a detection result, it is determined that there is an error in a receive data.

The receive data is a data in which a check bit is added to an input data by an encoding circuit (not shown) and is received through a transmission line. The transmission line is not limited to an ordinary communication channel, but can be adapted to a memory device in a memory system, and a transmit data can be adapted to write information to the memory device, and the receive data can be adapted to read information from the memory device.

Here, the transmit data which is added with the check bit and encoded, as described above, can be generally expressed by the binary number of n bits, and this transmit data can be expressed by $D = (d_0, d_1, ... d_{n-1})$ including the check bit of r bits.

The encoding, as described above, can be expressed by a parity check matrix (hereinafter, referred to as H matrix) of r columns and n rows which are ingredients of the binary number of 0 and 1, and if the transmit data is taken as a transmit data D, the bit of the H matrix is set up in such a manner as to establish the relationship of the equation (1). Consequently, between the transmit data D including no error and the H matrix, there is established the relationship of the equation (1).

The syndrome computing circuit 1a performs a computation of the equation (1) and obtains a computing result of the syndromes. This syndrome S is expressed by vector comprising r bits.

The error detecting circuit 1b determines that there is no error when the syndrome S indicates $S = 0$, and determines that there is an error when the syndrome S indicates $S \neq 0$. Further, the error pattern computing circuit 1c analyzes the pattern of the syndrome S based on the H matrix. The error pattern which is obtained can find the position and the size of the error included in the transmit data, and the data which includes an error can be corrected.

The syndrome computing circuit 1a, with respect to the transmit data D, performs a computation of the equation (1) by using the checkmatrix H used in the formation of the transmit data D. Here, if no error develops during the transmission, the receive data becomes identical with the transmit data, and therefore, the computing result obtained by taking the D in the left side of the equation (1) as a receive data becomes 0 (zero vector of r bits).

On the other hand, if an error develops, the computing result obtained by taking the D in the left side of the equation (1) as a receive data does not become 0.

By analyzing the vector of r bits of the pattern of this computing result based on the H matrix, the error position and size of the receive data can be found, and the receive data can be corrected.

The inverting circuit 1d figures out an exclusive OR of the error pattern computed by the error pattern computing circuit 1c and the receive data, thereby performing the correction of the receive data. When there is no error, the inverting circuit 1d outputs the inputted receive data as it is without inverting the same.

The error detecting circuit 1b of the present invention performs an error detection of the receive data based on the syndromes, and at the same time, outputs a request for extension of the cycle to the bus master 2 when an error is detected and the error is corrected by the error decoding circuit 1.

The request for extension of the cycle is a request for extending the cycle time of the bus cycle submitted to the bus master 2. The bus master 2, upon receipt of this request for extension, extends the cycle time of the data bus cycle, and performs a data processing based on the extended cycle time.

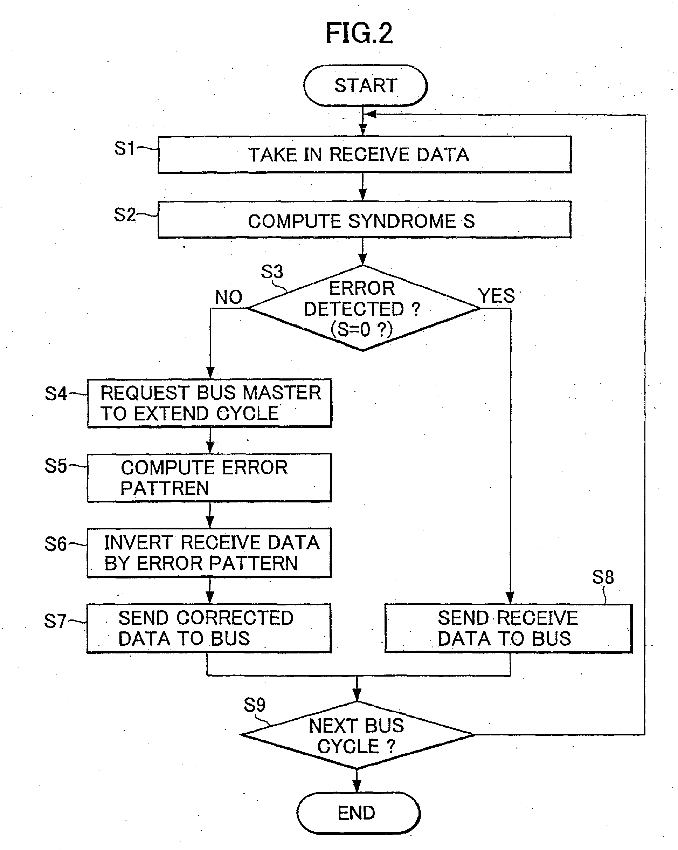

FIG. 2 is a flowchart to explain about the procedure of the error decoding circuit of the present invention.

The syndrome computing circuit 1a takes in the receive data (step S1), and computes the syndrome S (step S2). The error detecting circuit 1b determines the presence or absence of an error (step S3) based on whether or not the syndrome S is 0 (zero vector).

The error detecting circuit 1b determines that there is an error when the syndrome S is not 0 (zero vector) (step S3), and submits a request for extension of the cycle to the bus master 2 (step4) and allows the error pattern computing circuit 1c to compute an error pattern (step S5).

The inverting circuit 1d finds an exclusive OR of the error pattern obtained fromthe errorpattern computing circuit 1c and the receive data inputted, and corrects the receive data including the error (step S6) and outputs the corrected data (step S7).

On the other hand, the error detecting circuit 1b determines that there is no error when the syndrome S is 0 (zero vector) (step S3), and outputs the receive data inputted to the inverting circuit 1d without being inverted to the bus as it is (step S8). Consequently, when there is no error, the error pattern computing circuit 1c does not perform the computing processing of the error pattern. Further, when there is no error, the error detecting circuit 1b does not submit a request for extension of the cycle to the bus master 2.

The process of step S1 to step S8 is performed for each bus cycle, and at the next bus cycle time, the extended cycle time of the bus cycle is returned to a set value, and the process of step S1 to step S8 is repeated (step S9).

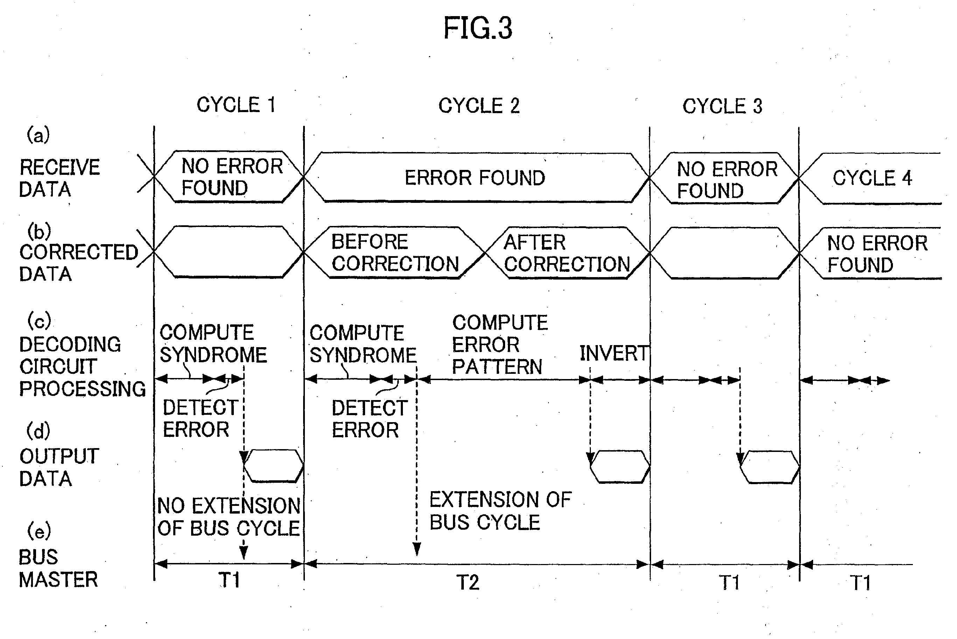

FIG. 3 is a view to explain about an extension processing of the cycle time of the data bus cycle according to the present invention, and shows an example including a cycle (cycles 1, 3 and 4) where there is no error in the receive data and a cycle (cycle 2) where there is an error.

In the cycle (cycles 1, 3 and 4) where there is no error in the receive data, the receive data 3 ((a) in FIG. 3) is processed within the bus cycle set to a cycle time T1, and a syndrome computing and an error detection are executed by the error decoding circuit, and the output data thereof ((d)) is outputted to a bus.

On the other hand, in the cycle (cycle 2) where there is an error in the receive data, the receive data ((a)) is, at first, processed within the bus cycle set to the cycle time T1, but when an error is detected by the syndrome computing and the error detection by the error decoding circuit 1, a request for extension of the cycle is submitted to the master bus 2. The bus mater 2, upon receipt of this request for extension of the cycle, extends the cycle time to T2 ((e)). The error decoding circuit 1 performs the error pattern computing processing and the inverting processing subsequent to the error detection within the extended cycle and outputs the corrected data in which the error is corrected to the bus.

When the extended bus cycle is completed, the bus master returns the bus cycle to the set cycle time T1 again, and continues the processing of the cycle 3.

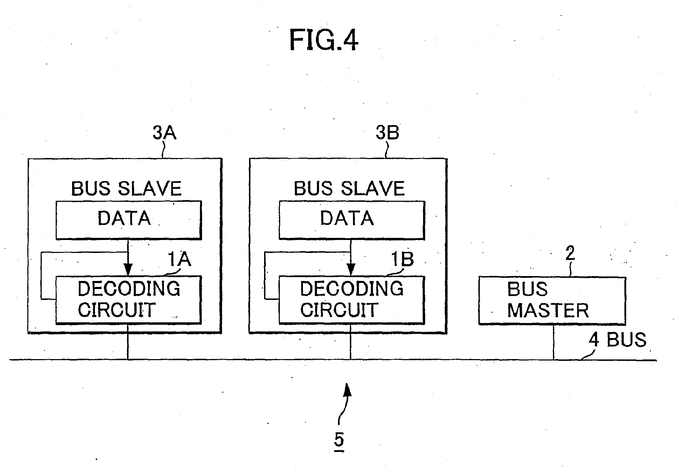

FIG. 4 is a block diagram to explain about the configuration of a data bas system. The data bus system 5 is composed by connecting the bus master 2 and bus slaves 3A and 3B through a bus 4.

The bus slaves can be made plural, and the bus slaves 3A and 3B each comprises error decoding circuits 1A and 1B each for decoding the received data. The bus master 2 controls and manages a plurality of bus slaves 3A and 3B on the bus 4. The bus master 2 performs the data processing of the bus slave 3 on the bus 4 according to the bus cycle set to a predetermined cycle time. This bus cycle, for example, can be set based on the time required for each bus slave to perform the processing on the data having no error.

The bus master 2 usually speeds up the data processing by setting up the bus cycle based on the processing time in which there is no error included in the receive data.

Where there is an error in the receive data in either of the bus salves 3A or 3B, the error decoding circuit performs the processing (error pattern computing processing and inverting processing) for correcting this error. The bus slave which performs this error correction submits a request for extension of the cycle to the bus master 2 at the time of detecting the error, and extends the cycle time so that the error correction processing such as the error pattern computing processing, the inverting processing and the like do not affect the next cycle. After the extended cycle is completed, the bus master 2 returns the extended cycle time to the original set cycle time.

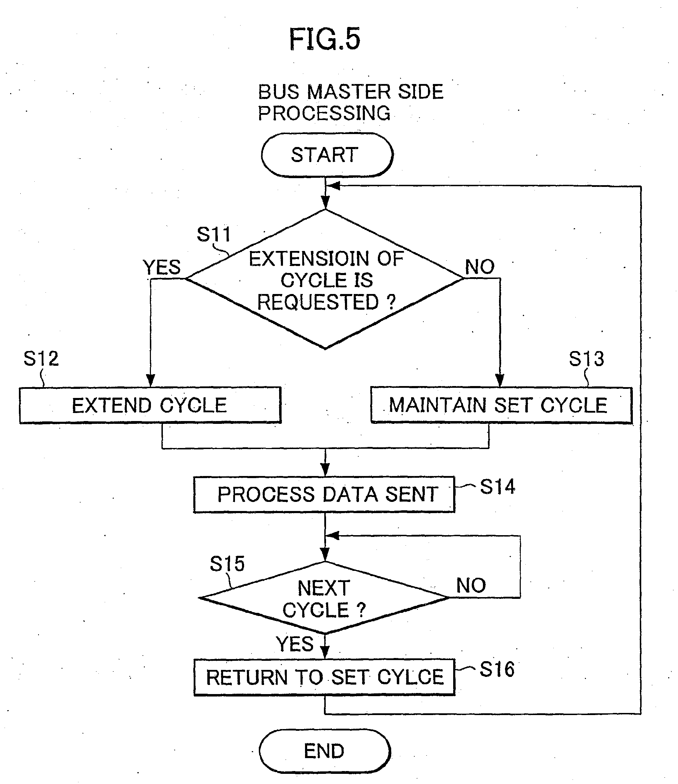

FIG. 5 is a flowchart to explain about the procedure of the processing of the bus master side of the present invention.

The bus master 2 monitors the request for extension of the cycle outputted from the bus slave 3 (step S11), and extends the cycle time when the request for extension of the cycle is outputted (step S12), and sets the cycle time as it is when no request for extension of the cycle is outputted (step S13).

The bus master processes the data sent from each bus slave 3 according to the extended cycle or the cycle in a set state (step S14). After the processing at one cycle is completed, and when the cycle is extended in the next cycle (step S15), the cycle is returned to the original set cycle (step S16), and the steps from S11 to S15 are repeated.

As described above, the technology of the present invention can be adapted to the device or the system which is capable of automatically correcting an error and is required to be highly reliable, and, for example, it can be adapted to industrial equipment and the system required to be normally operated under deteriorated conditions of the working environment due to temperatures, vibrations, noises and the like or the device and the system required to be highly reliable such as medical system, aerospace system and public systems.

## Claims

1. An error decoding circuit including an error correction processing of a receive data, said circuit comprising:

   a syndrome computing circuit for computing a syndrome on the receive data;
   an error detecting circuit for detecting an error based on said computed syndrome;
   an error pattern computing circuit for computing an error pattern based on said syndrome; and
   an inverting circuit for performing an error correction of a receive data based on said computed error pattern;

   wherein a request signal for extension of a bus cycle is submitted to a bus master when there is an error in the receive data based on the detection result of said error detecting circuit.

2. The error decoding circuit according to claim 1, wherein said inverting circuit inverts the receive data and corrects an error based on said computed error pattern.

3. The error decoding circuit according to claim 1, wherein,
   said error decoding circuit drives the error pattern computing circuit and outputs an request signal for extension of a bus cycle, when there is an error in the receive data, but,
   said error decoding circuit outputs the receive data inputted to the inverting circuit as it is, when there is no error in the receive data.

4. A control method for controlling a data bus, composed by connecting a bus master and at lease one bus slave through a bus, according to a bus cycle,
   wherein said bus cycle is changed based on a detection result of the detection of the error of the receive data in said bus slave.

5. A data bus control method according to claim 4, wherein saidbus slave performs the detection of the error of the receive data, and outputs a request signal for extension of the bus cycle based on the detection result of the detection of the error, while, on the other hand,
   said bus master extends the bus cycle based on said request signal, and performs a control of the data in the interior of the bus with the extended cycle.

6. The data bus control method according to claim 4 or 5,
   wherein said bus slave outputs a request signal for extension every time an error is detected in the receive data, and said bus master extends only one bus cycle for every output of said request signal for extension.

7. A data bus system composed by connecting a bus master and at least one bus slave through a bus,
   wherein said bus salve outputs a request signal for extending the bus cycle.

8. The data bus system according to claim 7, wherein said bus slave detects an error of the receive data, and comprises error detecting means for outputting the request signal for extending the cycle time of the bus cycle based on the detection result of said error detection, and
   wherein said bus master extends the bus cycle based on said request signal for extension, and comprises control means for controlling the data in the interior of the bus with said extended cycle time.

9. A data bus system composed by connecting a bus master and at least one bus slave through a bus,
   wherein said bus slave comprises the error decoding circuit recited in claim 1.

10. A decoding circuit, comprising:

    an error detecting circuit which computes, using a receive data D of the binary number of n bits including r check bits and a check matrix H of r columns and n rows, the following equation

    $$D \cdot H^T = S$$

    and determines that there is no error in the receive data D if the right side S (syndrome) is zero, but determines that there is an error in the receive data D if the right side S (syndrome) is not zero;
    an error pattern computing circuit for analyzing the pattern of said syndrome S based on said check matrix H and finding an error pattern including the position and the size of the error included in the receive data D;

error correcting means for performing the correction of the receive data D by figuring out an exclusive OR of the error pattern found by the error pattern computing circuit and the receive data D, thereby performing the correction of the receive data D, and

output means for outputting a request for extension of the cycle to the bus master;

wherein, when said error detecting circuit determines that there is an error in said receive data D, an error pattern included in the receive data D is found by said error pattern computing circuit, and the correction of the receive data D is performed by said error correction means, while, on the other hand,

when said error detecting circuit determines that there is no error in said receive data D, said output means is allowed to output a request for extension of the cycle to the bus master, without causing said error pattern computing circuit to find any error pattern included in the receive data D.

# FIG.1

RECEIVE DATA

1a
SYNDROME COMPUTING CIRCUIT

1b
ERROR DETECTING CIRCUIT

1c
ERROR PATTERN COMPUTIMG CIRCUIT

1d
INVERTING CIRCUIT (EXCLUSIVE OR)

CORRECTED DATA

REQUEST FOR EXTENSOIN OF CYCLE

2
BUS MASTER

# FIG.2

```
                    ┌─────────┐
                    │  START  │◄──────────────────────┐
                    └────┬────┘                       │
                         │                            │
          ┌──────────────▼───────────────────┐        │
    S1 ───┤      TAKE IN RECEIVE DATA         │        │
          └──────────────┬───────────────────┘        │
                         │                            │
          ┌──────────────▼───────────────────┐        │
    S2 ───┤      COMPUTE SYNDROME S           │        │
          └──────────────┬───────────────────┘        │
                         │                            │
                   S3    ▼                            │
              ◄────╱ ERROR     ╲────►                 │
           NO    ╱  DETECTED ?   ╲   YES              │
              ╲   ╲  (S=0 ?)   ╱  ╱                   │
               ╲   ╲─────────╱   ╲                    │
                │                 │                   │
    ┌───────────▼─────────┐       │                   │
S4 ─┤ REQUEST BUS MASTER  │       │                   │
    │ TO EXTEND CYCLE     │       │                   │
    └───────────┬─────────┘       │                   │
                │                 │                   │
    ┌───────────▼─────────┐       │                   │
S5 ─┤ COMPUTE ERROR       │       │                   │
    │ PATTREN             │       │                   │
    └───────────┬─────────┘       │                   │
                │                 │                   │
    ┌───────────▼─────────┐       │                   │
S6 ─┤ INVERT RECEIVE DATA │       │                   │
    │ BY ERROR PATTERN    │       │            S8     │
    └───────────┬─────────┘       │                   │
                │          ┌──────▼──────────┐        │
    ┌───────────▼─────────┐│  SEND RECEIVE   │        │
S7 ─┤ SEND CORRECTED      ││  DATA TO BUS    │        │
    │ DATA TO BUS         │└──────┬──────────┘        │
    └───────────┬─────────┘       │                   │
                │                 │                   │
                └─────────┬───────┘                   │
                    S9    ▼                           │
                      ╱ NEXT BUS ╲─────────────────────┘
                     ╱  CYCLE ?   ╲
                      ╲          ╱
                       ╲────┬───╱
                            │
                       ┌────▼────┐
                       │   END   │
                       └─────────┘
```

# FIG.3

CYCLE 1 | CYCLE 2 | CYCLE 3 | CYCLE 4

(a) RECEIVE DATA

NO ERROR FOUND | ERROR FOUND | NO ERROR FOUND

(b) CORRECTED DATA

BEFORE CORRECTION | AFTER CORRECTION | NO ERROR FOUND

(c) DECODING CIRCUIT PROCESSING

COMPUTE SYNDROME — DETECT ERROR

COMPUTE SYNDROME — DETECT ERROR — COMPUTE ERROR PATTERN — INVERT

(d) OUTPUT DATA

NO EXTENSION OF BUS CYCLE | EXTENSION OF BUS CYCLE

(e) BUS MASTER

T1 | T2 | T1 | T1

# FIG.4

# FIG.5

BUS MASTER SIDE
PROCESSING

START

S11 — EXTENSIOIN OF
CYCLE IS
REQUESTED ?

YES

NO

S12 — EXTEND CYCLE

S13 — MAINTAIN SET CYCLE

PROCESS DATA SENT — S14

S15 — NEXT
CYCLE ?

NO

YES

RETURN TO SET CYLCE — S16

END

# FIG.6

INPUT DATA

```
┌─────────────┐
│  ENCODING   │ ─10
│   CIRCUIT   │
└─────────────┘
```

TRANSMIT DATA

```
┌─────────────┐
│   TRANSMIS   │ ─11
│  SION LINE   │
└─────────────┘
```

RECEIVE DATA

```
┌─────────────┐
│    ERROR     │
│   DECODING   │ ─12
│   CIRCUIT    │
└─────────────┘
```

OUTPUT DATA

# FIG.7

|  | CYCLE 1 | CYCLE 2 | CYCLE 3 |
|---|---|---|---|

RECEIVE DATA — NO ERROR IN RECEIVE DATA — ERROR IN RECEIVE DATA — NO ERROR IN RECEIVE DATA

DECODING DATA — BEFORE DECODING / AFTER DECODING — BEFORE CORRECTION / AFTER CORRECTION — BEFORE DECODING / AFTER DECODING

OUTPUT — BEFORE DECODING — AFTER CORRECTION — BEFORE DECODING

T          T          T

EP 1 515 235 A1

# FIG.8

D0~DX
CRC0~CRCy
ECC0~ECCz

RECEIVE
DATA

12c D0~DX
CRC0~CRCy

12f

CRC CHECK
CIRCUIT

12a

ERROR
CORRECTION
CIRCUIT

12d

BUFFER
MEMORY

12b CRC CHECK
CIRCUIT

CORRECTED
DATA

12e

OUTPUT DATA

EP 1 515 235 A1

# FIG.9

|  | CYCLE A | CYCLE B |
|---|---|---|

(a) RECEIVE DATA — NO ERROR IN RECEIVE DATA | ERROR IN RECEIVE DATA

(b) CORRECTED DATA (ERROR CORRCTION CIRCUIT + CRC CHECK CIRCUIT) — BEFORE CORRECTION | BEFORE CORRECTION / AFTER CORREC-TION

(c) NON-CORRECTED DATA — RECEIVE DATA | RECEIVE DATA

(d) CRC CHECK OUTPUT — NO ERROR FOUND | ERROR FOUND

(e) OUTPUT DATA — RECEIVE DATA | AFTER CORREC-TION

T1

T2

# FIG.10

|  | CYCLE 1 | CYCLE 2 | CYCLE 3 |
|---|---|---|---|

**(a) RECEIVE DATA**

NO ERROR IN RECEIVE DATA | ERROR IN RECEIVE DATA | NO ERROR IN RECEIVE DATA

**(b) CORRECTED DATA(ERROR CORRECYION CIRCUIT + CRC CHECK CIRCUIT)**

AFTER CORRECTION

BEFORE CORRECTION | BEFORE CORRECTION | BEFORE CORRECTION

**(c) NON-CORRECTED DATA**

RECEIVE DATA | RECEIVE DATA | RECEIVE DATA

**(d) CRC CHECK OUTPUT**

NO ERROR FOUND | ERROR FOUND | NO ERROR FOUND

**(e) OUTPUT DATA**

RECEIVE DATA | AFTER CORRECTION | RECEIVE DATA

T2 | T2 | T2

**(f) BUS**

RECEIVE DATA | RECEIVE DATA | RECEIVE DATA

EP 1 515 235 A1

**European Patent Office**

EUROPEAN SEARCH REPORT

Application Number

EP 04 25 5401

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 517 508 A (SCOTT EDWARD W) 14 May 1996 (1996-05-14) | 1-6,8-10 | G06F11/10 H04L1/00 G06F11/07 |
| A | * column 5, line 4 - column 6, line 7 * * column 6, line 57 - column 9, line 29 * * figures 2,3 * ----- | 7 | |
| X | "PROGRAM CONTROLLED MICRO CHANNEL BUS CYCLE EXTENSION" IBM TECHNICAL DISCLOSURE BULLETIN, IBM CORP. NEW YORK, US, vol. 33, no. 7, 1 December 1990 (1990-12-01), pages 384-386, XP000108494 ISSN: 0018-8689 | 7 | |
| Y | * the whole document * ----- | 1-6,8-10 | |
| X | US 5 822 779 A (BAYDATCH YAIR ET AL) 13 October 1998 (1998-10-13) | 7 | |
| A | * column 3, line 45 - column 3, line 55 * * column 7, line 52 - column 7, line 67 * * column 10, line 18 - column 10, line 41 * * column 11, line 1 - column 11, line 12 * * column 14, line 21 - column 14, line 35 * * figures 3,11 * ----- -/-- | 1-6,8-10 | TECHNICAL FIELDS SEARCHED (Int.Cl.7) G06F H04L |

The present search report has been drawn up for all claims

| Place of search | Date of completion of the search | Examiner |
|---|---|---|
| Munich | 20 December 2004 | Johansson, U |

EPO FORM 1503 03.82 (P04C01)

European Patent Office

## EUROPEAN SEARCH REPORT

Application Number

EP 04 25 5401

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| A | US 5 629 949 A (ZOOK CHRISTOPHER P) 13 May 1997 (1997-05-13) * column 4, line 63 - column 6, line 67 * * column 10, line 65 - column 11, line 32 * * column 11, line 60 - column 12, line 53 * * column 16, line 53 - column 17, line 20 * * column 22, line 15 - column 22, line 55 * * figures 1,2 * ----- | 1-10 | |
| | | | **TECHNICAL FIELDS SEARCHED (Int.Cl.7)** |

The present search report has been drawn up for all claims

| Place of search | Date of completion of the search | Examiner |
|---|---|---|
| Munich | 20 December 2004 | Johansson, U |

EPO FORM 1503 03.82 (P04C01)

## ANNEX TO THE EUROPEAN SEARCH REPORT
## ON EUROPEAN PATENT APPLICATION NO.

EP 04 25 5401

This annex lists the patent family members relating to the patent documents cited in the above-mentioned European search report.
The members are as contained in the European Patent Office EDP file on
The European Patent Office is in no way liable for these particulars which are merely given for the purpose of information.

20-12-2004

| Patent document cited in search report | | Publication date | Patent family member(s) | | Publication date |
|---|---|---|---|---|---|
| US 5517508 | A | 14-05-1996 | JP | 7235880 A | 05-09-1995 |
| US 5822779 | A | 13-10-1998 | EP | 0601715 A1 | 15-06-1994 |
| | | | JP | 7006151 A | 10-01-1995 |
| US 5629949 | A | 13-05-1997 | US | 5602857 A | 11-02-1997 |
| | | | US | 5671237 A | 23-09-1997 |
| | | | US | 5446743 A | 29-08-1995 |
| | | | US | 5467297 A | 14-11-1995 |
| | | | US | 5491701 A | 13-02-1996 |
| | | | US | 5465260 A | 07-11-1995 |
| | | | US | 6125469 A | 26-09-2000 |
| | | | US | 5600662 A | 04-02-1997 |
| | | | US | 5724368 A | 03-03-1998 |
| | | | DE | 69429732 D1 | 14-03-2002 |
| | | | EP | 0729674 A1 | 04-09-1996 |
| | | | JP | 9507118 T | 15-07-1997 |
| | | | SG | 43012 A1 | 17-10-1997 |
| | | | WO | 9512921 A1 | 11-05-1995 |
| | | | DE | 69424877 D1 | 13-07-2000 |
| | | | DE | 69424877 T2 | 04-01-2001 |
| | | | EP | 0729611 A1 | 04-09-1996 |
| | | | JP | 9507117 T | 15-07-1997 |
| | | | SG | 47466 A1 | 17-04-1998 |
| | | | WO | 9512850 A1 | 11-05-1995 |
| | | | EP | 0727066 A1 | 21-08-1996 |
| | | | JP | 9507110 T | 15-07-1997 |
| | | | SG | 50474 A1 | 20-07-1998 |
| | | | WO | 9512845 A1 | 11-05-1995 |
| | | | US | 5555516 A | 10-09-1996 |
| | | | US | 5592404 A | 07-01-1997 |
| | | | US | 5668976 A | 16-09-1997 |
| | | | US | 6018626 A | 25-01-2000 |
| | | | EP | 0727068 A1 | 21-08-1996 |
| | | | SG | 50471 A1 | 20-07-1998 |
| | | | WO | 9512849 A1 | 11-05-1995 |
| | | | US | 5696775 A | 09-12-1997 |

EPO FORM P0459

For more details about this annex : see Official Journal of the European Patent Office, No. 12/82